# EUROPEAN PATENT APPLICATION

(11) **EP 4 842 147 A1**
(43) Date of publication of application: **18.11.2026**
(21) Application number: 26717880.4
(22) Date of filing: 05.03.2026
(51) Int. Cl.: H05K 1/14, H05K 1/02, H05K 7/20, H05K 1/11, H04M 1/02

(54) **ELECTRONIC DEVICE COMPRISING STRUCTURE FOR PREVENTING OVERFLOW OF HEAT TRANSFER MATERIAL OF STACKED SUBSTRATE**

(30) Priority: 28.03.2025 KR 20250040609; 23.06.2025 KR 20250082925
(71) Applicant: Samsung Electronics Co., Ltd, Suwon-si, Gyeonggi-do 16677 (KR)
(72) Inventor: PARK, Eunsoo, Suwon-si, Gyeonggi-do 16677 (KR); PARK, Jinwoo, Suwon-si, Gyeonggi-do 16677 (KR); KIM, Yongwoon, Suwon-si, Gyeonggi-do 16677 (KR); SHIN, Seungho, Suwon-si, Gyeonggi-do 16677 (KR); JIN, Suho, Suwon-si, Gyeonggi-do 16677 (KR)
(74) Representative: HGF
(86) International application number: PCT/KR2026/003503
(87) International publication number: WO 2026/205817

(57) **Abstract**

An electronic device according to various embodiments of the disclosure may include a housing, a multi-layered substrate disposed in the housing, at least one electronic component disposed in the housing, and a flexible circuit substrate configured to electrically connect the multi-layered substrate and the at least one electronic component. The multi-layered substrate may include an interposer disposed between a first substrate and a second substrate to electrically connect the first substrate and the second substrate, and a thermal interface material injected into a space defined by the first substrate, the second substrate, and the interposer through a first through-hole formed in the first substrate. The flexible circuit substrate may include a first rigid portion disposed at one end of the flexible circuit substrate and having a connector disposed thereon to be connected to a connection portion disposed on the first substrate, a second rigid portion spaced apart from the first rigid portion and including a first recess formed on one surface of the second rigid portion facing the first substrate, and a first flexible portion connecting the first rigid portion and the second rigid portion. When viewed in a direction perpendicular to a substrate surface of the first substrate, at least a portion of the first through-hole overlaps the first recess of the second rigid portion.

## Description

### [Technical Field]

Various embodiments disclosed herein relate to an electronic device including a structure for preventing overflow of a thermal interface material of a multi-layered substrate.

### [Background Art]

A multi-layered substrate is a structure widely used in response to demands for miniaturization and high integration of mobile terminals, and may allow efficient utilization of an internal space by laminating a plurality of substrates. In such a multi-layered substrate structure, a sealed space is formed inside, which causes a problem of deteriorated heat dissipation performance. To address this problem, a heat dissipation technology has been applied in which a thermal interface material is injected into the sealed space of the multi-layered substrate to effectively transfer heat of heat-generating components to the outside.

Meanwhile, when injecting a thermal interface material, there is a tendency to inject as much as possible in order to maximize heat dissipation performance. However, this may cause various problems such as electrical signal short-circuiting, deformation of the substrate, and deterioration in display quality due to the thermal interface material overflowing to the outside of the substrate.

In addition, depending on the arrangement structure of a rigid portion of a flexible circuit substrate and a connector, the connector may be disengaged from the substrate due to, for example, an external impact or movement of a battery. Accordingly, various structural improvements are required to address both the problem of preventing overflow of the thermal interface material and the problem of preventing connector detachment.

### [Disclosure of Invention]

### [Technical Problem]

Various embodiments of the disclosure provide an electronic device capable of preventing overflow of a thermal interface material injected into a sealed space of a multi-layered substrate while solving or alleviating a connector disengagement problem caused by an arrangement structure of a rigid portion of a flexible circuit substrate and a connector.

### [Solution to Problem]

An electronic device according to various embodiments of the disclosure may include a housing, a multi-layered substrate disposed in the housing, at least one electronic component disposed in the housing, and a flexible circuit substrate configured to electrically connect the multi-layered substrate and the at least one electronic component. The multi-layered substrate may include an interposer disposed between a first substrate and a second substrate to electrically connect the first substrate and the second substrate, and a thermal interface material injected into a space defined by the first substrate, the second substrate, and the interposer through a first through-hole formed in the first substrate. The flexible circuit substrate may include a first rigid portion disposed at one end of the flexible circuit board and having a first connector connected to a connection portion disposed on the first substrate, a second rigid portion spaced apart from the first rigid portion and including a first recess formed one surface of the second rigid portion facing the first substrate, and a first flexible portion connecting the first rigid portion and the second rigid portion. When viewed in a direction perpendicular to the substrate surface of the first substrate, at least a portion of the first through-hole overlaps the first recess of the second rigid portion.

According to an embodiment, the electronic device may further include a first cover member disposed on the substrate surface of the first substrate to close the first through-hole. In addition, the electronic device may further include a first elastic member which comprises a first opening corresponding to the first recess and is disposed between the first cover member and the second rigid portion. At this time, the first elastic member may be configured to press the first cover member.

The first flexible portion may have a thickness smaller than that of the first rigid portion and that of the second rigid portion. The second rigid portion may have a thickness greater than that of the first rigid portion.

According to an embodiment, the flexible circuit substrate may include a third rigid portion positioned opposite to the second rigid portion with reference to the first rigid portion, and a second flexible portion connecting the first rigid portion and the third rigid portion. When viewed in a direction perpendicular to the substrate surface of the first substrate, at least a portion of a second through-hole formed in the first substrate may overlap the third rigid portion. The third rigid portion of the flexible circuit substrate may include a second recess overlapping the second through-hole. The electronic device may further include a second cover member disposed on the substrate surface of the first substrate to close the second through-hole. In addition, the electronic device may further include a second elastic member which includes a second opening corresponding to the second recess and is disposed between the second cover member and the third rigid portion. The second rigid portion and the third rigid portion are positioned diagonally with respect to a longitudinal direction of the first rigid portion.

The electronic device may further include a battery disposed between the flexible circuit board and the at least one electronic component. The flexible circuit substrate may include a fourth rigid portion disposed at one end of the flexible circuit board, a second connector disposed in the fourth rigid portion and connected to the at least one electronic component, and a connection portion configured to connect the first rigid portion and the fourth rigid portion and overlapping the battery when viewed in a direction perpendicular to the substrate surface of the first substrate.

The housing may include a first housing, a second housing, and a hinge assembly configured to rotatably connect the first housing and the second housing about a folding axis, and the longitudinal side of the first connector of the multi-layered substrate may be parallel to the folding axis.

The first cover member may have an incision portion formed therein into which a dispenser configured to inject the thermal interface material is inserted.

According to another embodiment, the flexible circuit substrate may include a first rigid portion disposed at one end of the flexible circuit substrate and having a connector disposed thereon to be connected to a connection portion disposed on the first substrate, a second rigid portion spaced apart from the first rigid portion, and a first flexible portion connecting the first rigid portion and the second rigid portion, and when viewed in a direction perpendicular to the substrate surface of the first substrate, at least a portion of the first through-hole may overlap the second rigid portion. In this case, the housing may include a first housing, a second housing, and a hinge assembly configured to rotatably connect the first housing and the second housing about a folding axis, and the longitudinal side of the second rigid portion of the multi-layered substrate may be parallel to the folding axis. The first flexible portion may have a thickness smaller than that of the first rigid portion and that of the second rigid portion, and the second rigid portion may have a thickness greater than that of the first rigid portion. The electronic device may further include a first cover member disposed on the substrate surface of the first substrate to close the first through-hole, and the first cover member may have an incision portion formed therein into which a dispenser configured to inject the thermal interface material is inserted.

### [Advantageous Effects of Invention]

In the electronic device according to various embodiments of the disclosure, in order to prevent thermal interface material injected into the sealed space of the multi-layered substrate from overflowing to the outside, the first recess is formed in the second rigid portion of the flexible circuit substrate and disposed to overlap the first through-hole of the multi-layered substrate. As a result, the overflow of the thermal interface material may be effectively suppressed.

In addition, by connecting the first rigid portion and the second rigid portion of the flexible circuit substrate with a first flexible portion, disengagement of the connector may be prevented despite tilting of a stiffener that may occur due to pressure of the thermal interface material.

The effects obtainable from the electronic device according to various embodiments of the disclosure are not limited to the effects mentioned above, and other effects not described herein will be clearly understood by those ordinarily skilled in the art from the description of this specification.

### [Brief Description of Drawings]

In connection with the description of the drawings, the same or similar components may be denoted by the same or similar reference numerals.
FIG. 1A is a front perspective view of an electronic device according to various embodiments of the disclosure in an unfolded state.
FIG. 1B is a view illustrating the front surface of the electronic device according to various embodiments of the disclosure in the unfolded state.
FIG. 1C is a view illustrating the rear surface of the electronic device according to various embodiments of the disclosure in the unfolded state.
FIG. 2A is a rear perspective view of the electronic device according to various embodiments of the disclosure in a folded state.
FIG. 2B is a perspective view illustrating the electronic device according to various embodiments of the disclosure in an intermediate state.
FIG. 3 is an exploded perspective view of the electronic device according to various embodiments of the disclosure.
FIG. 4 is a view illustrating a first substrate of an electronic device according to various embodiments of the disclosure as viewed from above.
FIGS. 5 to 8 are cross-sectional views of the electronic device of FIG. 4, taken along line C1-C2, according to various embodiments of the disclosure.
FIG. 9 is a view illustrating movement of the second rigid portion when overflow occurs as a liquid thermal interface material passes through the first cover member in the cross-sectional view of FIG. 8.
FIG. 10 is a view illustrating a state when overflow occurs as a liquid thermal interface material passes through the first cover member in the cross-sectional view of FIG. 8.
FIG. 11 is a schematic view illustrating a first rigid portion, a second rigid portion, and a first flexible portion, as viewed from above.
FIG. 12 is a view illustrating a case where the width of the first flexible portion of FIG. 11 is adjusted.
FIG. 13A is a schematic view illustrating a case where the number of layers of the first flexible portion is increased.
FIG. 13B is a schematic view illustrating a case where the number of layers of the first flexible portion is reduced.
FIG. 14 is a schematic view illustrating a first rigid portion, a second rigid portion, and a third rigid portion, as viewed from above.
FIG. 15 is a view illustrating a top surface of a flexible circuit substrate.
FIG. 16 is a view illustrating a bottom surface of the flexible circuit substrate.

### [Mode for the Invention]

Hereinafter, various embodiments of the disclosure will be described with reference to the accompanying drawings. It should be appreciated that the embodiments and the terms used therein are not intended to limit the technological features set forth herein to particular embodiments and the disclosure includes various changes, equivalents, or alternatives for a corresponding embodiment.

With regard to the description of the drawings, similar reference numerals may be used to designate similar or relevant elements. A singular form of a noun corresponding to an item may include one or more of the items, unless the relevant context clearly indicates otherwise.

As used herein, each of such phrases as "A or B," "at least one of A and B," "at least one of A or B," "A, B, or C," "at least one of A, B, and C," and "at least one of A, B, or C" may include all possible combinations of the items enumerated together in a corresponding one of the phrases. Such terms as "a first," "a second," "the first," and "the second" may be used to simply distinguish a corresponding element from another, and does not limit the elements in other aspect (e.g., importance or order). If an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

Hereinafter, embodiments of the disclosure will be described in detail with reference to the drawings so that those skilled in the art to which the disclosure pertains can easily implement the disclosure. However, the disclosure may be implemented in various different forms and is not limited to embodiments set forth herein. With regard to the description of the drawings, the same or like reference signs may be used to designate the same or like elements. Also, in the drawings and the relevant descriptions, description of well-known functions and configurations may be omitted for the sake of clarity and brevity.

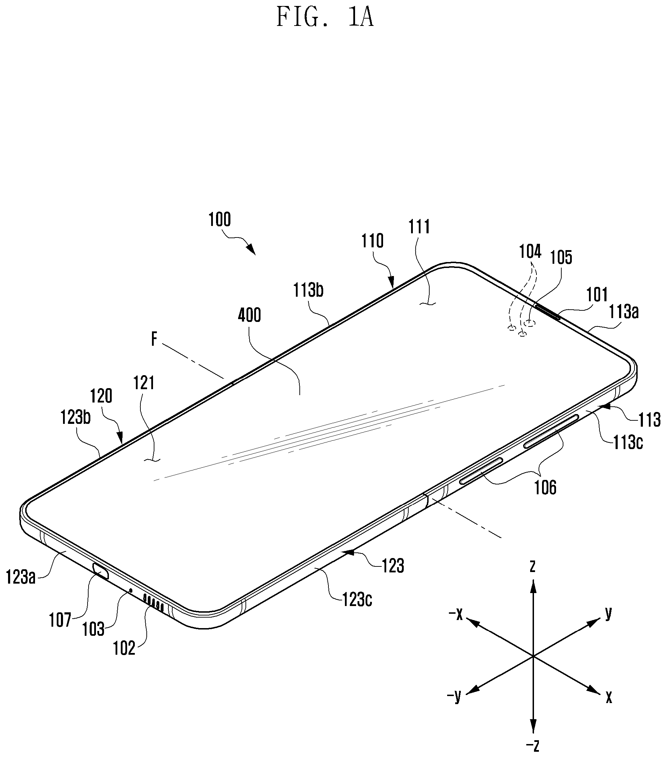

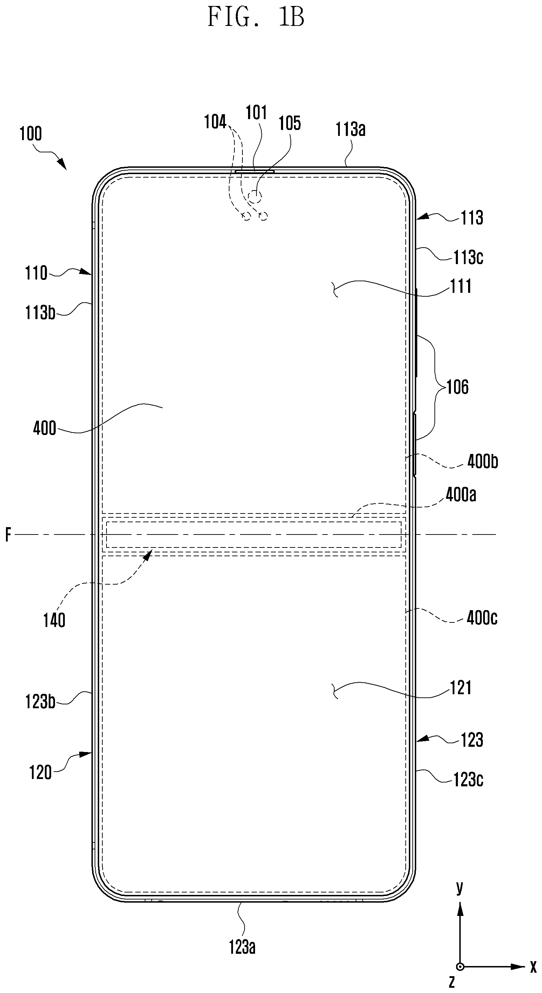

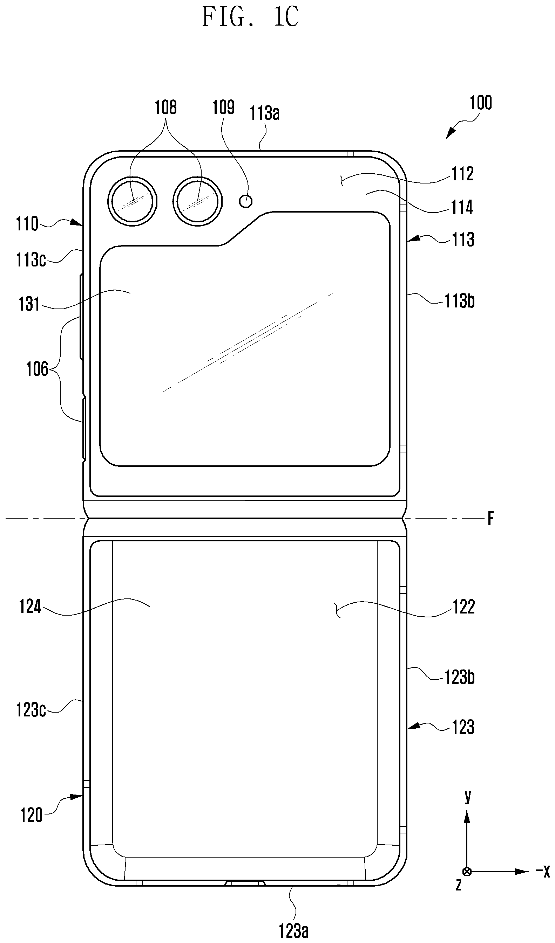

FIG. 1A is a perspective view of an electronic device illustrating an unfolded state (or flat state) of the electronic device according to various embodiments of the disclosure. FIG. 1B is a plan view illustrating a front surface of an electronic device in an unfolded state of the electronic device according to various embodiments of the disclosure. FIG. 1C is a plan view illustrating a rear surface of an electronic device in an unfolded state according to various embodiments of the disclosure.

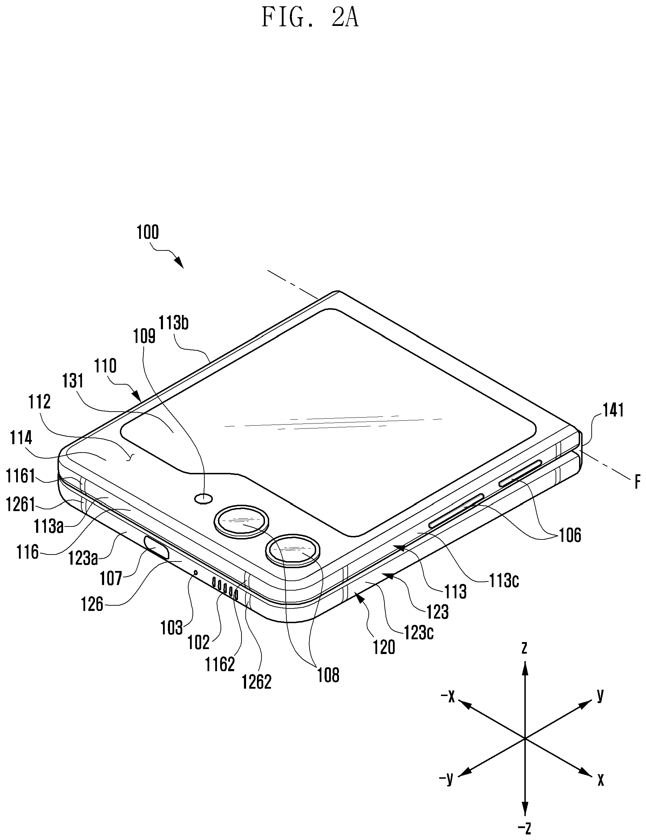

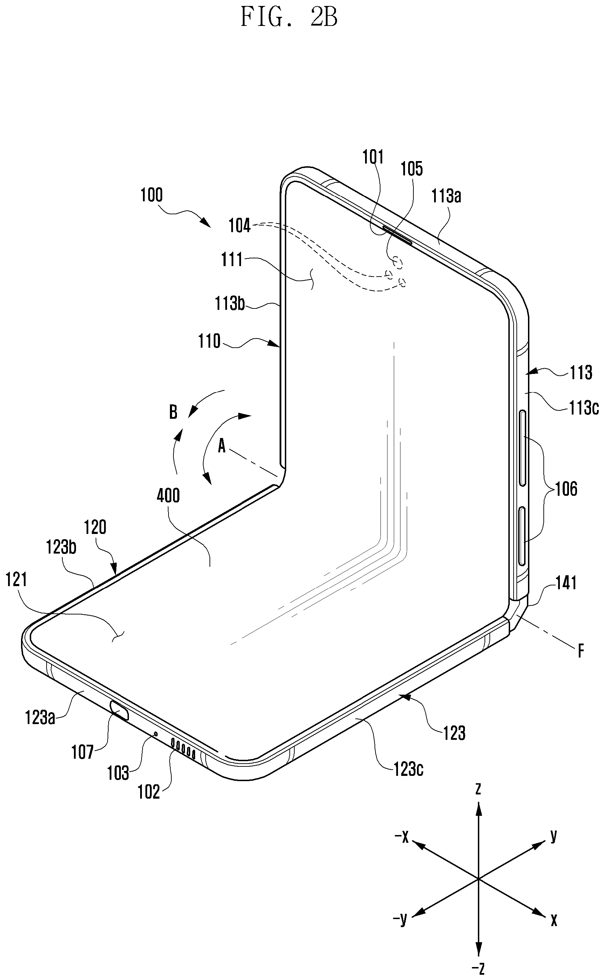

FIG. 2A is a perspective view of an electronic device illustrating a folded state of the electronic device according to various embodiments of the disclosure. FIG. 2B is a perspective view of an electronic device illustrating an intermediate state of the electronic device according to various embodiments of the disclosure.

With reference to FIGS. 1A to 2B, an electronic device 100 may include first and second housings 110 and 120 (e.g., foldable housing structure) combined with each other in a foldable manner based on a hinge device (e.g., hinge device 140 of FIG. 1B). In an embodiment, the hinge device (e.g., hinge device 140 of FIG. 1B) may be disposed in an X-axis direction or in a Y-axis direction. According to an embodiment, the electronic device 100 may include a first display 400 (e.g., flexible display, foldable display, or main display) disposed in an area (e.g., recess) formed by the first and second housings 110 and 120. According to an embodiment, the first housing 110 and the second housing 120 may be disposed on both sides around a folding axis F, and may have a substantially symmetrical shape about the folding axis F. According to an embodiment, an angle or a distance between the first housing 110 and the second housing 120 may differ depending on the state of the electronic device 100. For example, depending on whether the electronic device is in an unfolded state (or flat state), in a folded state, or in an intermediate state, the angle or the distance between the first housing 110 and the second housing 120 may differ.

According to an embodiment, in the unfolded state of the electronic device 100, the first housing 110 may include a first surface 111 directed in a first direction (e.g., front direction) (z-axis direction), and a second surface 112 directed in a second direction (e.g., rear direction) (-z-axis direction) opposite to the first surface 111. According to an embodiment, in the unfolded state of the electronic device 100, the second housing 120 may include a third surface 121 directed in the first direction (z-axis direction), and a fourth surface 122 directed in the second direction (-z-axis direction). According to an embodiment, in the unfolded state of the electronic device 100, the first surface 111 of the first housing 110 and the third surface 121 of the second housing 120 may be directed in substantially the same first direction (z-axis direction). In an embodiment, in the folded state of the electronic device 100, the first surface 111 of the first housing 110 and the third surface 121 of the second housing 120 may face each other. According to an embodiment, in the unfolded state of the electronic device 100, the second surface 112 of the first housing 110 and the fourth surface 122 of the second housing 120 may be directed in substantially the same second direction (-z-axis direction). In an embodiment, in the folded state of the electronic device 100, the second surface 112 of the first housing and the fourth surface 122 of the second housing 120 may be directed in opposite directions. For example, in the folded state of the electronic device 100, the second surface 112 may be directed in the first direction (z-axis direction), and the fourth surface 122 may be directed in the second direction (-z-axis direction). In this case, the first display 400 may not be viewed from outside (in-folding manner). In an embodiment, the electronic device 100 may be folded so that the second surface 112 of the first housing 110 and the fourth surface 122 of the second housing 120 face each other. In this case, the first display 400 may be disposed to be viewed from the outside (out-folding manner).

According to various embodiments, the first housing 110 (e.g., first housing structure) may include a first lateral member 113 forming the appearance of the electronic device 100, and a first rear cover 114 combined with the first lateral member 113, and forming at least a part of the second surface 112 of the electronic device 100. According to an embodiment, the first lateral member 113 may include a first side surface 113a, a second side surface 113b extending from one end of the first side surface 113a, and a third side surface 113c extending from the other end of the first side surface 113a. According to an embodiment, the first lateral member 113 may be formed in a quadrangular (e.g., square or rectangular) shape through the first side surface 113a, the second side surface 113b, and the third side surface 113c.

According to various embodiments, the second housing 120 (e.g., second housing structure) may include a second lateral member 123 forming the appearance of the electronic device 100 at least partly, and a second lateral cover 124 combined with the second lateral member 123, and forming at least a part of the fourth surface 122 of the electronic device 100. According to an embodiment, the second lateral member 123 may include a fourth side surface 123a, a fifth side surface 123b extending from one end of the fourth side surface 123a, and a sixth side surface 123c extending from the other end of the fourth side surface 123a. According to an embodiment, the second lateral member 123 may be formed in a quadrangular shape through the fourth side surface 123a, the fifth side surface 123b, and the sixth side surface 123c.

According to various embodiments, the first and second housings 110 and 120 are not limited to the illustrated shapes and combinations, but may be implemented by combinations and/or compositions of other shapes or components. In an embodiment, the first lateral member 113 may be integrally formed with the first rear cover 114, and the second lateral member 123 may be integrally formed with the second rear cover 124.

According to various embodiments, in the unfolded state of the electronic device 100, the second side surface 113b of the first lateral member 113 and the fifth side surface 123b of the second lateral member 123 may be connected to each other without a gap. According to an embodiment, in the unfolded state of the electronic device 100, the third side surface 113c of the first lateral member 113 and the sixth side surface 123c of the second lateral member 123 may be connected to each other without a gap. According to an embodiment, in the unfolded state of the electronic device 100, the sum of the lengths of the second side surface 113b and the fifth side surface 123b may be configured to be longer than the length of the first side surface 113a and/or the fourth side surface 123a. According to an embodiment, in the unfolded state of the electronic device 100, the sum of the lengths of the third side surface 113c and the sixth side surface 123c may be configured to be longer than the length of the first side surface 113a and/or the fourth side surface 123a.

With reference to FIGS. 2A and 2B, the first lateral member 113 and/or the second lateral member 123 may be formed of metal, or may further include polymer that is injected into metal. According to an embodiment, the first lateral member 113 and/or the second lateral member 123 may include at least one conductive part 116 and/or 126 electrically segmented through at least one segment part 1161, 1162 and/or 1261, 1262 formed of polymer. In this case, the at least one conductive part 116 and/or 126 may be electrically connected to a wireless communication circuit included in the electronic device 100, and thus may be used as at least a part of an antenna that operates in at least one designated band (e.g., legacy band).

According to various embodiments, the first rear cover 114 and/or the second rear cover 124 may be formed of, for example, at least one of coated or colored glass, ceramic, polymer, or metal (e.g., aluminum, stainless steel (STS), or magnesium) or a combination of at least two thereof.

According to various embodiments, the first display 400 may be disposed to extend from the first surface 111 of the first housing 110 to at least a part of the third surface 121 of the second housing 120 across the hinge device (e.g., hinge device 140 of FIG. 1B). In an embodiment, the first display 400 may include a first area 130a substantially corresponding to the first surface 111, a second area 130b corresponding to the second surface 121, and a third area 130c (e.g., flexible area or folding area) connecting the first area 130a and the second area 130b to each other. According to an embodiment, the third area 130c may be a part of the first area 120a and/or the second area 130b, and may be disposed at a location corresponding to the hinge device (e.g., hinge device 140 of FIG. 1B). According to an embodiment, the electronic device 100 may include a hinge housing 141 (e.g., hinge cover) supporting the hinge device (e.g., hinge device 140 of FIG. 1B). In an embodiment, the hinge housing 141 may be disposed to be exposed to outside when the electronic device 100 is in a folded state, and not to be viewed from the outside as being drawn into an inner space of the first housing 110 and an inner space of the second housing 120 when the electronic device 100 is in an unfolded state.

According to various embodiments, the electronic device 100 may include a second display 131 (e.g., sub-display) disposed separately from the first display 400. According to an embodiment, the second display 131 may be disposed to be exposed at least partly on the second surface 112 of the first housing 110. In an embodiment, when the electronic device 100 is in the folded state, the second display 131 may display at least a part of state information of the electronic device 100 in replacement of at least a part of a display function of the first display 400. According to an embodiment, the second display 131 may be disposed to be viewed from the outside through at least a partial area of the first rear cover 114. In an embodiment, the second display 131 may be disposed on the fourth surface 122 of the second housing 120. In this case, the second display 131 may be disposed to be viewed from the outside through at least a partial area of the second rear cover 124.

According to various embodiments, the electronic device 100 may include at least one of an input device 103 (e.g., microphone), sound output devices 101 and 102, a sensor module 104, camera devices 105 and 108, a key input device 106, or a connector port 107. In an illustrated embodiment, although the input device 103 (e.g., microphone), the sound output devices 101 and 102, the sensor module 104, the camera devices 105 and 108, the key input device 106, or the connector port 107 are illustrated as hole or circular shaped elements formed on the first housing 110 or the second housing 120, they are exemplarily illustrated for explanation, but are not limited thereto. According to various embodiments, the input device 103 may include at least one microphone 103 disposed on the second housing 120. In an embodiment, the input device 103 may include a plurality of microphones 103 disposed to sense the sound direction. In an embodiment, the plurality of microphone 103 may be disposed at proper locations on the first housing 110 and/or the second housing 120. According to an embodiment, the sound output devices 101 and 102 may include at least one speaker 101 and 102. According to an embodiment, the at least one speaker 101 and 102 may include a receiver 101 for call disposed on the first housing 110, and the speaker 102 disposed on the second housing 120. In an embodiment, the input device 103, the sound output devices 101 and 102, and the connector port 107 may be disposed in a space provided in the first housing 110 and/or the second housing 120 of the electronic device 100, and may be exposed to an external environment through at least one hole formed on the first housing 110 and/or the second housing 120. According to an embodiment, the at least one connector port 107 may be used to transmit and receive power and/or data to and from an external electronic device. In an embodiment, the at least one connector port (e.g., ear jack hole) may accommodate a connector (e.g., ear jack) for transmitting and receiving an audio signal to and from the external electronic device. In an embodiment, the hole formed on the first housing 110 and/or the second housing 120 may be commonly used for the input device 103 and the sound output devices 101 and 102. In an embodiment, the sound output devices 101 and 102 may include a speaker (e.g., piezo-electric speaker) that is not exposed through the hole formed on the first housing 110 and/or the second housing 120.

According to various embodiments, the sensor module 104 may generate an electrical signal or a data value corresponding to an internal operation state of the electronic device 100 or an external environment state. According to an embodiment, the sensor module 104 may detect the external environment through the first surface 111 of the first housing 110. In an embodiment, the electronic device 100 may further include at least one sensor module disposed to detect the external environment through the second surface 112 of the first housing 110. According to an embodiment, the sensor module 104 (e.g., illumination sensor) may be disposed to detect the external environment through the first display 400 under the first display 400. According to an embodiment, the sensor module 104 may include at least one of a gesture sensor, a gyro sensor, a barometric pressure sensor, a magnetic sensor, an acceleration sensor, a grip sensor, a color sensor, an infrared (IR) sensor, a biosensor, a temperature sensor, a humidity sensor, an illumination sensor, a proximity sensor, a biosensor, an ultrasonic sensor, or an illumination sensor 104.

According to various embodiments, the camera devices 105 and 108 may include the first camera device 105 (e.g., front camera device) disposed on the first surface 111 of the first housing 110, and the second camera device 108 disposed on the second surface 112 of the first housing 110. In an embodiment, the electronic device 100 may further include a flash 109 disposed near the second camera device 108. According to an embodiment, the camera devices 105 and 108 may include at least one lens, an image sensor, and/or an image signal processor. According to an embodiment, the camera devices 105 and 108 may be disposed so that two or more lenses (e.g., wide angle lens, ultra wide angle lens, or telephoto lens) and two or more image sensors are located on one surface (e.g., first surface 111, second surface 112, third surface 121, or fourth surface 122) of the electronic device 100. In an embodiment, the camera devices 105 and 108 may include lenses for time of flight (TOF) and/or image sensors.

According to various embodiments, the key input device 106 (e.g., key buttons) may be disposed on the third side surface 113c of the first lateral member 113 of the first housing 110. In an embodiment, the key input device 106 may be disposed on at least one side surface of other side surfaces 113a and 113b of the first housing 110 and/or side surfaces 123a, 123b, and 123c of the second housing 120. In an embodiment, the electronic device 100 may not include some or all of the key input devices 106, and the non-included key input device 106 may be implemented in another form, such as a soft key, on the first display 400. In an embodiment, the key input device 106 may be implemented by using the pressure sensor included in the first display 400.

According to various embodiments, one of the camera devices 105 and 108 (e.g., first camera device 105) or the sensor module 104 may be disposed to be exposed through the first display 400. According to an embodiment, the first camera device 105 or the sensor module 104 may be optically exposed to the outside through an opening (e.g., through-hole) formed at least partly on the first display 400 in the inner space of the electronic device 100. According to an embodiment, at least a part of the sensor module 104 may be disposed not to be visually exposed through the first display 400 in the inner space of the electronic device 100. With reference to FIG. 2B, the electronic device 100 may operate to maintain at least one designated folding angle in an intermediate state through the hinge device (e.g., hinge device 140 of FIG. 1B). In this case, the electronic device 100 may control the first display 400 so that different kinds of content are displayed on the display area corresponding to the first surface 111 and the display area corresponding to the third surface 121. According to an embodiment, the electronic device 100 may operate in substantially the unfolded state (e.g., unfolded state of FIG. 1A) and/or in substantially the folded state (e.g., folded state of FIG. 2A) based on a specific folding angle (e.g., angle between the first housing 110 and the second housing 120 when the electronic device 100 is in the intermediate state) through the hinge device (e.g., hinge device 140 of FIG. 1B). In an embodiment, if a pressing force is provided in an unfolding direction (direction A) in a state where the electronic device 100 is unfolded at the specific folding angle through the hinge device (e.g., hinge device 140 of FIG. 1B), the electronic device 100 may operate to be transitioned to the unfolded state (e.g., unfolded state of FIG. 1A). In an embodiment, if the pressing force is provided in a folding direction (direction B) in a state where the electronic device 100 is unfolded at the specific folding angle through the hinge device (e.g., hinge device 140 of FIG. 1B), the electronic device 100 may operate to be transitioned to the folded state (e.g., folded state of FIG. 2A). In an embodiment, the electronic device 100 may operate to maintain the unfolded state (not illustrated) at various angles through the hinge device (e.g., hinge device 140 of FIG. 1B) (free-stop function).

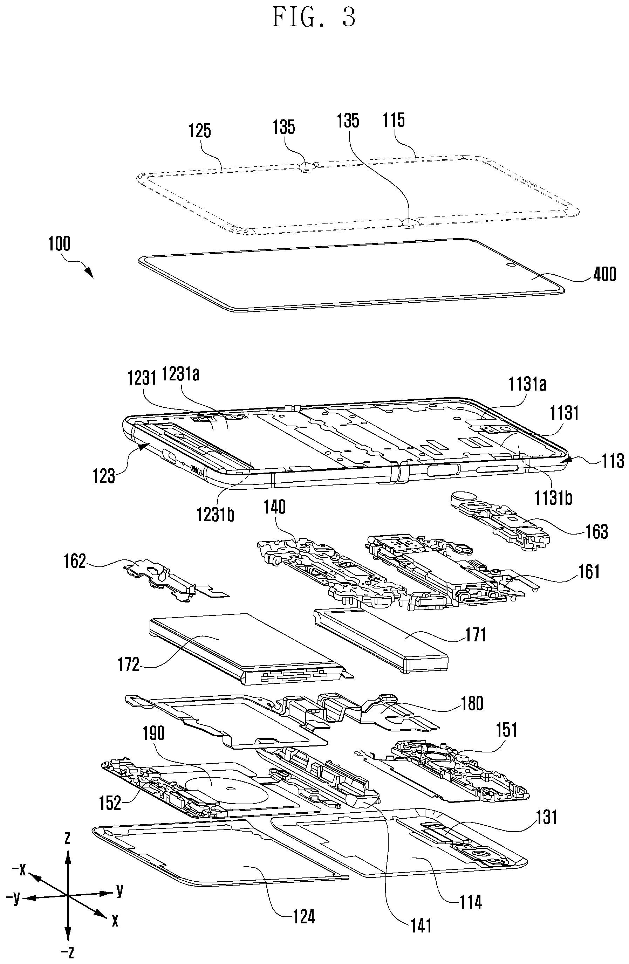

FIG. 3 is an exploded perspective view of the electronic device according to various embodiments of the disclosure.

Referring to FIG. 3, an electronic device 100 may include a first side surface member 113 (e.g., a first side surface frame), a second side surface member 123 (e.g., a second side surface frame), and a hinge device 140 (e.g., a hinge module or hinge structure) configured to rotatably connect the first side surface member 113 and the second side surface member 123 to each other. In an embodiment, the electronic device 100 may include a first support member 1131 (e.g., a first support plate or a first extension member) extending at least partially from the first side surface member 113, and a second support member 1231 (e.g., a second support plate or a second extension member) extending at least partially from the second side surface member 123. In an embodiment, the first support member 1131 may be integrally formed with or structurally coupled to the first side surface member 113. In an embodiment, the second support member 1231 may be integrally formed with or structurally coupled to the second side surface member 123. In an embodiment, a first display 400 may be disposed so as to be supported by the first support member 1131 and the second support member 1231. In an embodiment, the electronic device 100 may include a first rear surface cover 114 coupled to the first side surface member 113 and providing a first space between the first rear surface cover 114 and the first support member 1131, and a second rear surface cover 124 coupled to the second side surface member 123 and providing a second space between the second rear surface cover 124 and the second support member 1231. In an embodiment, the first side surface member 113 and the first rear surface cover 114 may be integrally formed. In an embodiment, the second side surface member 123 and the second rear surface cover 124 may be integrally formed. In an embodiment, the first housing 110 may include the first side surface member 113, the first support member 1131, and the first rear surface cover 114. In an embodiment, the second housing 120 may include the second side surface member 123, the second support member 1231, and the second rear surface cover 124. In an embodiment, the electronic device 100 may include a second display 131 disposed to be visible from the outside through at least a portion of the first rear surface cover 114.

According to various embodiments, the electronic device 100 may include a first circuit board 161 (e.g., a first circuit board assembly or a main printed circuit board), a camera assembly 163, a first battery 171, or a first bracket 151 disposed in the first space between the first side surface member 113 and the first rear surface cover 114. In an embodiment, the camera assembly 163 may include a plurality of camera devices (e.g., the camera devices 105 and 108 of FIGS. 1A and 2A) and may be electrically connected to the first circuit board 161. In an embodiment, the first bracket 151 may provide a support structure for supporting the first substrate 161 and/or the camera assembly 163 and improved rigidity. In an embodiment, the electronic device 100 may include a second substrate 162 (e.g., a second substrate assembly or a sub-printed circuit board), an antenna 190 (e.g., a coil member), a second battery 172, or a second bracket 152 disposed in the second space between the second side surface member 123 and the second rear surface cover 124. In an embodiment, the electronic device 100 may include a wiring member 180 (e.g., a flexible printed circuit board (FPCB)) disposed to extend from the first substrate 161 across the hinge device 140 to a plurality of electronic components (e.g., the second substrate 162, the second battery 172, or the antenna 190) disposed between the second side surface member 123 and the second rear surface cover 124, thereby providing electrical connection. In an embodiment, the antenna 190 may include a near field communication (NFC) antenna, a wireless charging antenna, and/or a magnetic secure transmission (MST) antenna.

According to various embodiments, the electronic device 100 may further include a first protection cover 115 (e.g., a first protection frame or a first decoration member) coupled along an edge of the first housing 110, and a second protection cover 125 (e.g., a second protection frame or a second decoration member) coupled along an edge of the second housing 120. In an embodiment, the first protection cover 115 and/or the second protection cover 125 may be formed of a metal or polymer material. In an embodiment, the first protection cover 115 and/or the second protection cover 125 may be used as a decoration member. In this case, the first display 400 may be disposed such that an edge of a first flat portion 400b is not visible from the outside between the first housing 110 and the first protection cover 115. In an embodiment, the first display 400 may be disposed such that an edge of a second flat portion 400c is not visible from the outside between the second housing 120 and the second protection cover 125.

According to various embodiments, the electronic device 100 may further include a protection cap 135 disposed to protect an edge of a bending portion of the first display 400 (e.g., the bending portion 400a of FIG. 1B). In this case, the first display 400 may have its edge protected by the protection cap 135 disposed at a position corresponding to the bending portion (e.g., the bending portion 400a of FIG. 1B). In an embodiment, the first protection cover 115 and/or the second protection cover 125 may be omitted. In an embodiment, the protection cap 135 may be omitted.

According to various embodiments, the first support member 1131 may include a first support surface 1131a oriented in a first direction (e.g., the z-axis direction) and a second support surface 1131b oriented in a second direction (e.g., the -z-axis direction) opposite to the first direction. In an embodiment, the second support member 1231 may include, in an unfolded state of the electronic device 100, a third support surface 1231a oriented in the first direction and a fourth support surface 1231b oriented in the second direction. In an embodiment, the first display 400 may be disposed so as to be supported by the first support surface 1131a of the first support member 1131 and the third support surface 1231a of the second support member 1231.

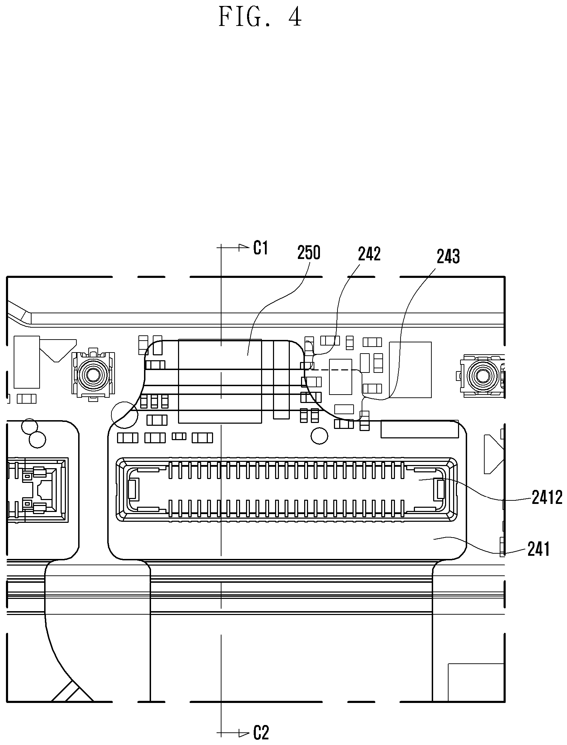

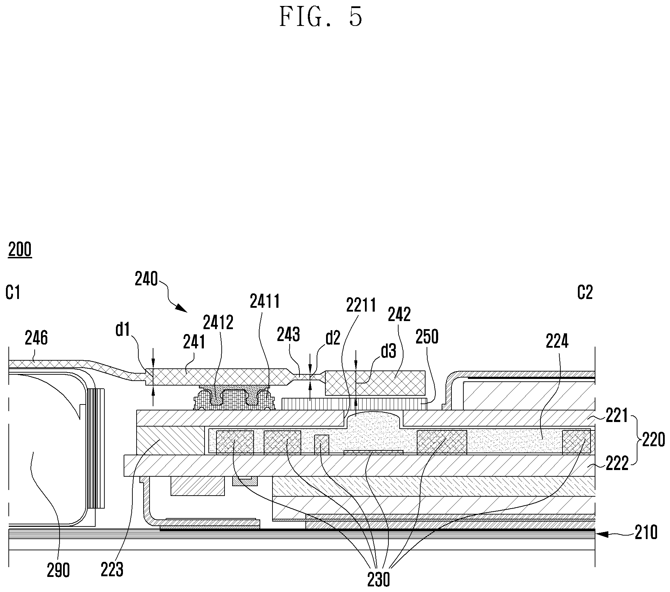

FIG. 4 is a view illustrating a first substrate as viewed from above, according to various embodiments of the disclosure. FIGS. 5 to 8 are cross-sectional views of the electronic device of FIG. 4, taken along line C1-C2, according to various embodiments of the disclosure.

Hereinafter, with reference to FIGS. 4 to 8, features and arrangement relationships of components constituting an electronic device according to various embodiments of the disclosure will be described in detail.

In various embodiments of the disclosure, an electronic device 200 may include a housing 210, a multi-layered substrate 220, at least one electronic component 230, and a flexible circuit substrate 240. The electronic device 200 may have the multi-layered substrate 220 disposed inside the housing 210. The multi-layered substrate 220 may be electrically connected to the at least one electronic component 230. The flexible circuit substrate 240 may transfer signals between the multi-layered substrate 220 and the at least one electronic component 230. The housing 210 may protect the multi-layered substrate 220 and the flexible circuit substrate 240 from external impact. The multi-layered substrate 220 may be formed in a multi-layered structure such that the electronic component 230 may be mounted in a space between a plurality of substrates. The flexible circuit substrate 240 may be designed to have a bendable structure so as to be disposed in a limited space inside the housing 210.

In various embodiments of the disclosure, the electronic device 200 may include a first housing 110, a second housing 120, and a hinge device 140. The first housing 110 and the second housing 120 may be rotatably connected via the hinge device 140. The hinge device 140 may adjust a relative position of the first housing 110 and the second housing 120 with reference to a folding axis F. The electronic device 200 may implement a foldable structure to allow a user to fold or unfold the housing 210. The multi-layered substrate 220 or the electronic component 230 may be disposed in each of the first housing 110 and the second housing 120.

In an embodiment, the multi-layered substrate 220 may form a multi-layered structure to provide an electrical connection and heat transfer path within the electronic device 200. The multi-layered substrate 220 may be implemented in a structure in which a plurality of insulation layers and conductive layers are alternately laminated. Each conductive layer may be used as a signal line, a power line, or a ground line. A heat transfer path may be provided inside the multi-layered substrate 220 so as to transfer heat generated from the electronic component 230 to the outside. For example, some of the conductive layers of the multi-layered substrate 220 may be formed of a metal having high thermal conductivity so as to transfer heat to the housing 210 or a heat dissipation plate.

The multi-layered substrate 220 may include a first substrate 221, a second substrate 222, an interposer 223, and a thermal interface material 224. The first substrate 221 and the second substrate 222 may be disposed spaced apart from each other, and the interposer 223 may be positioned between the first substrate 221 and the second substrate 222 to provide electrical connection. The thermal interface material 224 may form a heat transfer path in a sealed space.

The first substrate 221 and the second substrate 222 may be disposed with a predetermined spacing therebetween. The spacing space may be utilized as a space for placement of the interposer 223 and the thermal interface material 224. The spacing distance may be designed considering a mounting height of the electronic component 230 and heat transfer efficiency.

The interposer 223 may be disposed between the first substrate 221 and the second substrate 222 to transfer electrical signals. In this case, the interposer 223 may include a sealing structure at an outer portion thereof, thereby forming a sealed space to prevent leakage of the thermal interface material 224. For example, the sealing structure of the interposer 223 may be implemented with silicone, rubber, or an adhesive.

The sealed space may be used as a space for injection and retention of the thermal interface material 224. The interposer 223 may also perform a mechanical support role to fix a relative position of the first substrate 221 and the second substrate 222.

In addition, the interposer 223 may include a plurality of conductive patterns to transfer signals and power between the first substrate 221 and the second substrate 222.

The thermal interface material 224 may be injected into the sealed space through a first through-hole 2211 formed in the first substrate 221. The thermal interface material 224 may contact the first substrate 221, the second substrate 222, and the interposer 223 within the sealed space to form a heat transfer path.

The thermal interface material 224 may be injected into the sealed space through the first through-hole 2211 formed in the first substrate 221. In this case, the first through-hole 2211 may be formed as a passage for injection of the thermal interface material 224. The thermal interface material 224 may be injected into the first through-hole 2211 through an injection nozzle or a dispenser. The injected thermal interface material 224 may fill the sealed space to form a heat transfer path. During the injection process, a pressure change in the sealed space may occur, and the size and position of the through-hole may be designed considering the pressure change. The injection nozzle may be closely attached to the first through-hole 2211 to prevent leakage of the thermal interface material 224. The injection speed and pressure may be adjusted according to the viscosity of the thermal interface material 224 and the volume of the sealed space. For example, the injection process may be performed using an automated facility to accurately inject a constant amount of the thermal interface material 224.

The thermal interface material 224 may include silicone oil, grease, or a polymer-based thermally conductive material. The filled thermal interface material 224 may increase heat transfer efficiency and suppress a temperature rise of the electronic component 230.

The flexible circuit substrate 240 may include a first rigid portion 241, a second rigid portion 242, and a first flexible portion 243. The first rigid portion 241 may be disposed at one end of the flexible circuit substrate 240. The second rigid portion 242 may be disposed spaced apart from the first rigid portion 241. The first flexible portion 243 may connect the first rigid portion 241 and the second rigid portion 242.

The first rigid portion 241 may be disposed at one end of the flexible circuit substrate 240. The first rigid portion 241 may be positioned at an end of the flexible circuit substrate 240 to support connection with an external circuit or the multi-layered substrate 220. The first rigid portion 241 may have an increased thickness structure to provide mechanical support during fastening of a connector.

In an embodiment, the first rigid portion 241 may include a first connector 2412 connected to a connection portion 2411 disposed on the first substrate 221.

The first connector 2412 may be mounted on a surface of the first rigid portion 241. The first connector 2412 may be electrically connected to the connection portion 2411 of the first substrate 221 in correspondence therewith. The first connector 2412 may include a plurality of pins or contact structures. In this case, a fastening direction and position of the connector may be determined according to a shape of the first rigid portion 241, and may be implemented in a board-to-board (BTB) type or a zero insertion force (ZIF) type.

The connection portion 2411 may be disposed on one surface of the first substrate 221 and may correspond to the first connector 2412 to form an electrical connection relationship.

The second rigid portion 242 may be disposed spaced apart from the first rigid portion 241 with the first flexible portion 243 interposed therebetween. The spaced-apart structure may be designed to secure bending characteristics of the first flexible portion 243, and the spacing distance may be determined according to an overall length of the flexible circuit substrate 240 and a placement structure thereof in the housing 210.

The second rigid portion 242 may be designed independently of the mounting position of the first connector 2412 or the electronic component 230, and may be disposed to overlap the first recess 2421, the first through-hole 2211, and a first cover member 250 to be described later, thereby supporting a sealing structure of a thermal interface material 224 injection portion.

In an embodiment, the thickness d3 of the second rigid portion 242 may be greater than the thickness d1 of the first rigid portion 241. As illustrated in FIG. 5, the second rigid portion 242 according to an embodiment may directly press the first cover member 250. Accordingly, the thickness d3 of the second rigid portion 242 may be configured to a thickness capable of pressing the first cover member 250 so as to increase adhesion with the first cover member 250, thereby enhancing an effect of preventing overflow of the thermal interface material 224. In this case, the electronic device 200 according to an embodiment of the disclosure may prevent contact disengagement or signal short-circuiting of the first connector 2412 by increasing the thickness d3 of the second rigid portion 242.

In an embodiment, optimization of the thickness d3 of the second rigid portion 242 may contribute to adjusting mechanical rigidity of the entire flexible circuit substrate 240. The thickness d3 of the second rigid portion 242 may adjust bending stiffness of the flexible circuit substrate 240 to improve durability of the overall structure, and optimization of the thickness d3 of the second rigid portion 242 may equalize stress distribution generated during an assembly process of the electronic device 200.

In at least one embodiment of the disclosure, the second rigid portion 242 may include a first recess 2421 formed on one surface thereof facing the first substrate 221.

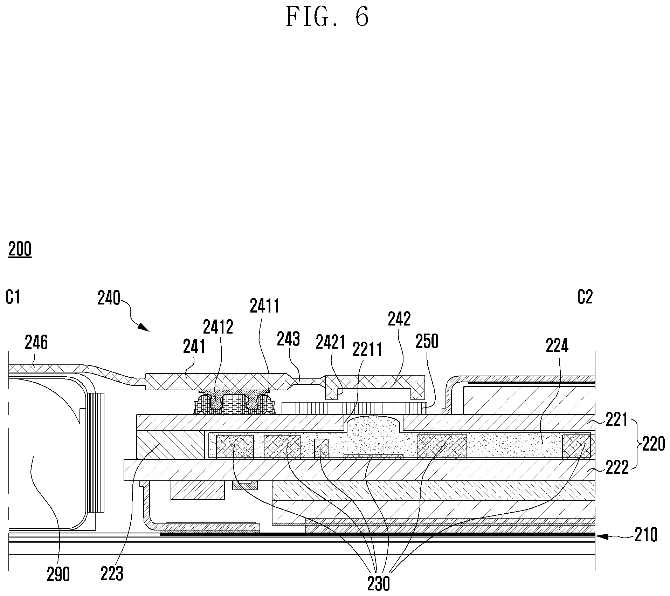

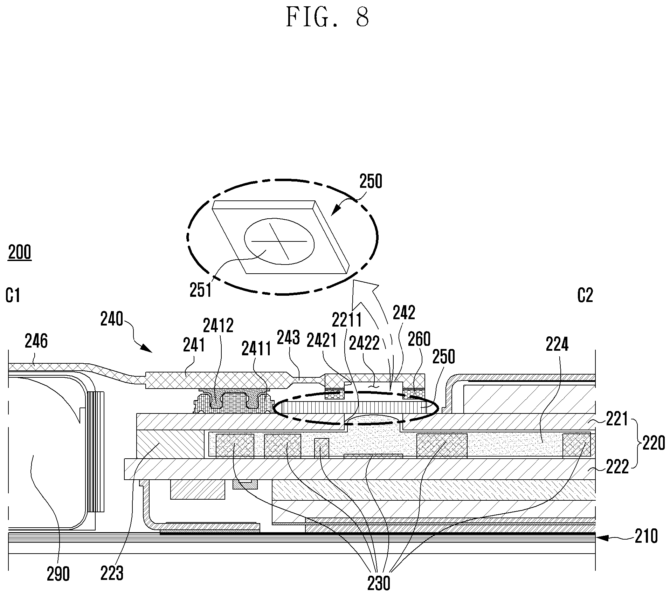

As illustrated in FIGS. 6 and 8, the first recess 2421 may be formed as a depressed structure in a lower surface of the second rigid portion 242. The first recess 2421 may overlap a through-hole of the first substrate 221 so as to prevent the thermal interface material 224 from overflowing to the outside of the second rigid portion 242. Accordingly, the depth and area of the first recess 2421 may be designed according to the size and position of the first through-hole 2211. In this case, the first recess 2421 may be a concave structure formed by cutting some laminated layers of a stiffener.

The first recess 2421 may serve to prevent overflow of the thermal interface material 224.

Referring to FIGS. 6 and 8, in various embodiments of the disclosure, the first recess 2421 of the second rigid portion 242 may be disposed to overlap the first through-hole 2211 so as to primarily block overflow of the thermal interface material 224. Such an overlapping structure may allow the thermal interface material 224 to temporarily remain inside the first recess 2421 after being injected through the first through-hole 2211. Accordingly, even when an injection amount of the thermal interface material 224 increases, the overlapping structure may minimize external leakage.

Specifically, by cutting a portion of some laminated layers of the second rigid portion 242 to form the first recess 2421, a cavity may be secured between the second rigid portion 242 and a cover for the thermal interface material 224. The first recess 2421 may be concavely processed in the lower portion of the second rigid portion 242 so as to form an empty space between the rigid portion 242 and the first cover member 250. The cavity may serve as a space capable of temporarily accommodating the overflowed thermal interface material 224. The first recess 2421 and the cavity structure may contribute to preventing external leakage of the thermal interface material 224.

In at least one embodiment of the disclosure, the first recess 2421 and the cavity structure may provide a space for accommodating the overflowed thermal interface material 224 to prevent external leakage of the thermal interface material 224. The overflowed thermal interface material 224 may remain inside the first recess 2421 and the cavity, and external diffusion thereof may be blocked. The volume of the cavity may be designed in accordance with an expected overflow amount of the thermal interface material (TIM). The first recess 2421 and the cavity structure may broaden a tolerance of the thermal interface material 224 injection process.

In an embodiment, the first recess 2421 and the cavity structure may alleviate an effect of displacement of the second rigid portion 242 by additionally securing a distance (in the z-axis direction) between a stiffener and a cover for the thermal interface material 224. In addition, the first recess 2421 and the cavity structure may minimize deformation of the second rigid portion 242 even under repetitive external impact, and may mitigate stress concentration resulting from the displacement of the second rigid portion 242.

The first flexible portion 243 may connect the first rigid portion 241 and the second rigid portion 242. In an embodiment, the first flexible portion 243 may be formed of a flexible insulating material to provide electrical and mechanical connection between the first rigid portion 241 and the second rigid portion 242, and may allow bending. The first flexible portion 243 may include electrical signal lines and ground lines, and may transfer signals and power between the first rigid portion 241 and the second rigid portion 242. The first flexible portion 243 may prevent short-circuiting or disconnection of conductive patterns even under bending, twisting, or repetitive deformation, and may be designed to allow repeated bending even in an area with a small radius of curvature.

In an embodiment, thickness and stress control of the flexible area may affect durability, flexibility, and connector support force of the flexible circuit substrate 240. The thickness of the flexible area may directly affect durability in a repetitive bending environment. Stress control may alleviate stress concentration generated at the boundary between the rigid portion and the flexible portion, thereby improving structural reliability.

In an embodiment, the thickness d2 of the first flexible portion 243 may be smaller than the thickness d1 of the first rigid portion 241 and the thickness d3 of the second rigid portion 242. The thickness d2 of the first flexible portion 243 may be designed in a range of 0.05 mm to 0.15 mm, and the thickness d3 of the first rigid portion 241 and the second rigid portion 242 may be formed to be 0.2 mm or greater. The thickness difference may reduce the bending radius of the flexible portion and may maintain mechanical support strength of the rigid portion. The small thickness of the first flexible portion 243 may contribute to reducing the overall thickness of the electronic device 200. In this case, by designing the thickness d2 of the first flexible portion 243 to be small, the electronic device 200 according to an embodiment may ensure the bending flexibility of the flexible circuit substrate 240 and enable it to operate without cracks or electrical signal short-circuiting during repetitive folding operations.

In addition, a thickness difference between the first flexible portion 243 and the first rigid portion 241 and the second rigid portion 242 may alleviate stress concentration at boundaries with the rigid portions, thereby improving overall structural reliability. The thickness difference between the first flexible portion 243 and the rigid portions may induce stress distribution by applying a curved or tapered structure to boundary areas. When stress concentration is alleviated, cracks or delamination at junctions of the first flexible portion 243 and the rigid portions may be reduced.

In various embodiments of the disclosure, the electronic device 200 may include a first cover member 250 disposed on the substrate surface of the first substrate 221 to close the first through-hole 2211.

The first cover member 250 may seal the first through-hole 2211 to prevent leakage of the heat transfer material 224. The first cover member 250 may be bonded to an edge of the first through-hole 2211 via an adhesive layer, thereby blocking the injected heat transfer material 224 from leaking to the outside. Accordingly, the first cover member 250 may perform protection and sealing functions for a heat transfer path inside the multi-layered substrate 220. In this case, the first cover member 250 may be made of a silicone or rubber material for sealing, and may be made of a material having excellent heat resistance and chemical resistance so as to prevent damage to the heat transfer path.

Meanwhile, since the first cover member 250 is arranged to be closely attached to one surface of the first substrate 221 by a soldering method, the surface of the first cover member 250 that is in contact with the first substrate 221 may be made of a metal material capable of being soldered.

In addition, the first cover member 250 may prevent foreign substances from entering the inside of the multi-layered substrate 220.

Referring to FIG. 8, the first cover member 250 may include an incision portion 251 into which a dispenser configured to inject the thermal interface material 224 is inserted. The incision portion 251 of the first cover member 250 may be processed to have a size that allows insertion of a nozzle of the dispenser during the injection process. The incision portion 251 may be designed as a self-recovery structure that automatically restores after injection. The incision portion 251 may maintain a sealed state even after injection of the thermal interface material 224 without a separate sealing process.

In addition, the incision portion 251 may include a guide mark for accurately guiding the injection position. The incision portion 251 may be formed of a material having restoring force so as to prevent residual thermal interface material 224 from leaking to the outside after injection, and may be designed to have a structure with little deformation even under repeated injection processes.

In various embodiments of the disclosure, the electronic device 200 may include a first opening 2422 corresponding to the first recess 2421 and a first elastic member 260 disposed between the first cover member 250 and the second rigid portion 242.

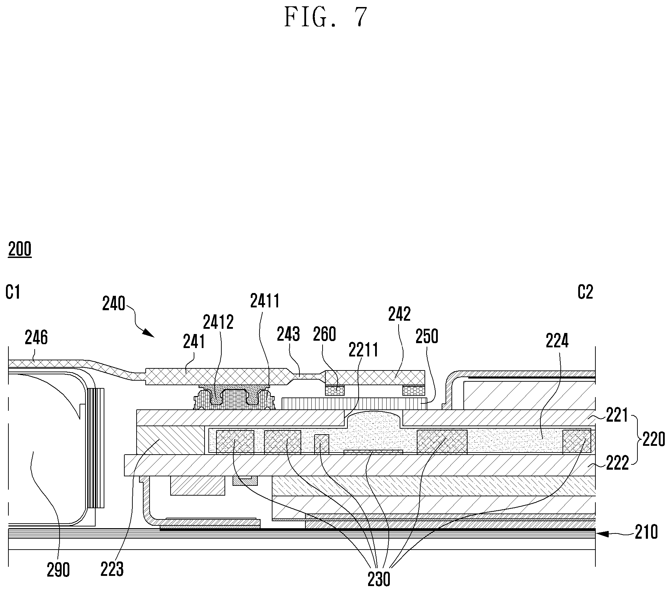

As illustrated in FIGS. 7 and 8, the first elastic member 260 may be inserted into a space between the first cover member 250 and the second rigid portion 242 to press the first cover member 250. The first elastic member 260 may press the first cover member 250 downward using restoring force. The pressing force of the first elastic member 260 may be designed to be sufficient to maintain the sealed state of the cover member. The first elastic member 260 may be made of a highly elastic material, such as rubber, sponge, or polyurethane, which undergoes little deformation even under repetitive pressing.

The pressing action of the first elastic member 260 may prevent overflow of the thermal interface material 224 by pressing the first cover member 250. The first elastic member 260 may suppress deformation of the cover member and block the thermal interface material 224 from leaking to the outside. In this case, the first elastic member 260 may minimize a gap between the cover member and the second rigid portion 242 so as to maximize a sealing effect. In addition, by maintaining the pressed state of the cover member, the first elastic member 260 may provide stable sealing even when the injection amount of the thermal interface material 224 varies.

The first opening 2422 may be disposed to precisely engage with the first recess 2421 of the second rigid portion 242.

The first opening 2422 may be disposed to correspond to the first recess 2421 of the second rigid portion 242, and may be designed to have the same position and size as the first recess 2421 of the second rigid portion 242. The first opening 2422 may secure an injection path of the thermal interface material 224 while enhancing stability of the sealed space. In addition, the first opening 2422 may include a fine filter structure to prevent inflow of external foreign substances.

In at least one embodiment of the disclosure, the electronic device 200 may further include a battery 290 disposed between the flexible circuit substrate 240 and the at least one electronic component 230 in the housing 210.

The battery 290 may be electrically connected to the multi-layered substrate 220 to supply power. The battery 290 may serve to absorb heat inside the housing 210 and release the heat to the outside.

The battery 290 may be disposed parallel to one surface of the electronic component 230 to improve space utilization. The overlapping arrangement of the battery 290 may minimize an unused space inside the housing 210, thereby supporting miniaturization of the electronic device 200. In this case, the overlapping structure of the battery 290 may optimize wiring and component arrangement inside the housing 210 and contribute to reducing the thickness of the electronic device 200.

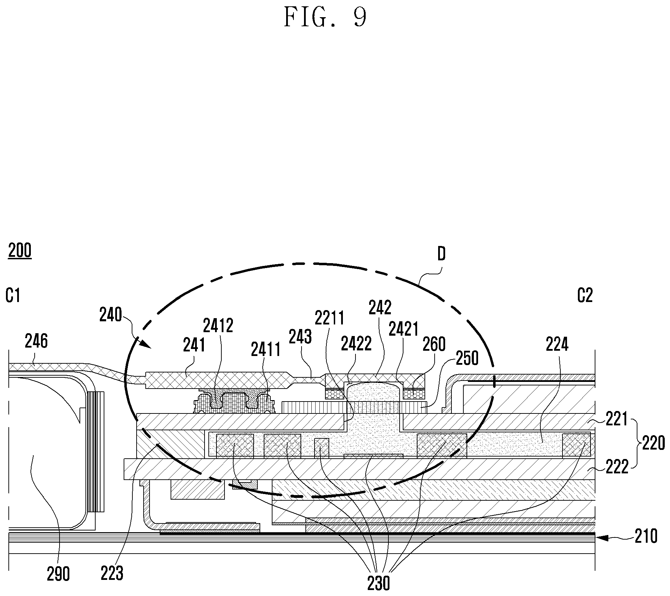

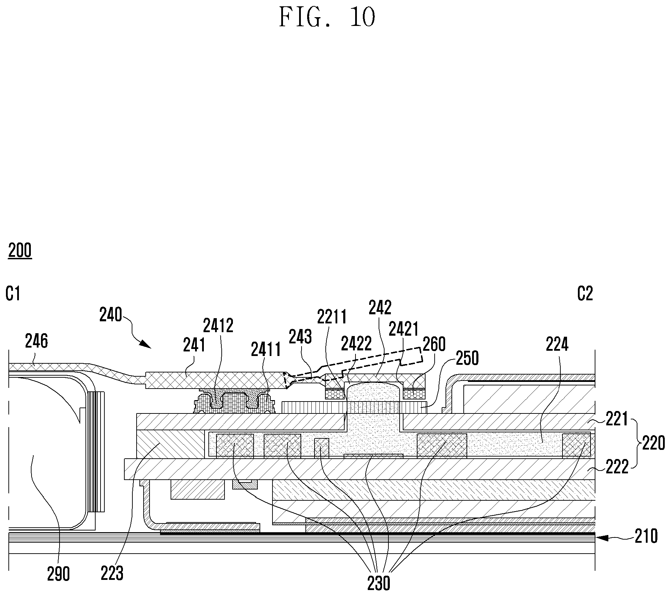

FIG. 9 is a view illustrating movement of the second rigid portion when overflow occurs as a liquid thermal interface material passes through the first cover member in the cross-sectional view of FIG. 8. FIG. 10 is a view illustrating a state when overflow occurs as a liquid thermal interface material passes through the first cover member in the cross-sectional view of FIG. 8.

Referring to FIGS. 9 and 10, a mechanism for preventing disengagement of the first connector 2412 according to overflow of the thermal interface material 224 will be described.

As illustrated in FIG. 8, the thermal interface material 224 may be maintained in a filled state inside the multi-layered substrate 220 without being discharged to the outside through the first cover member 250. Meanwhile, when the thermal interface material 224 expands due to external impact or heat, the thermal interface material 224 may be discharged to the outside of the first cover member 250, as illustrated in FIG. 9.

In an embodiment of the disclosure, the electronic device 200 may include a first flexible portion 243 formed between the first rigid portion 241 and the second rigid portion 242 of the flexible circuit substrate 240, thereby constituting an articulated structure. Such an articulated structure may allow only the second rigid portion 242 to be lifted by utilizing bending characteristics of the first flexible portion 243. The articulated structure may stably maintain the position of the first rigid portion 241 when external impact is applied or when the thermal interface material 224 is excessively injected.

Accordingly, when the thermal interface material 224 is excessively injected, or when pressure of the thermal interface material 224 increases due to expansion caused by external impact or heat, only the second rigid portion 242 may be lifted upward across the first flexible portion 243, as illustrated in FIG. 10. At this time, the first rigid portion 241 may be maintained in position by a reaction force of the first flexible portion 243. Thus, lifting of only the second rigid portion 242 may contribute to preventing the disengagement of a connector.

In an embodiment, the articulated structure may prevent the disengagement of the first connector 2412 by maintaining the first rigid portion 241 of the first connector 2412 in place. The articulated structure may adjust the reaction force of the first flexible portion 243 so that the first rigid portion 241 of the first connector 2412 is not displaced by external force. Prevention of disengagement of the first connector 2412 may enhance fastening reliability of the first connector 2412 and prevent electrical connection failure. At this time, the articulated structure may maintain the position of the first connector 2412 stably even under repetitive external impact.

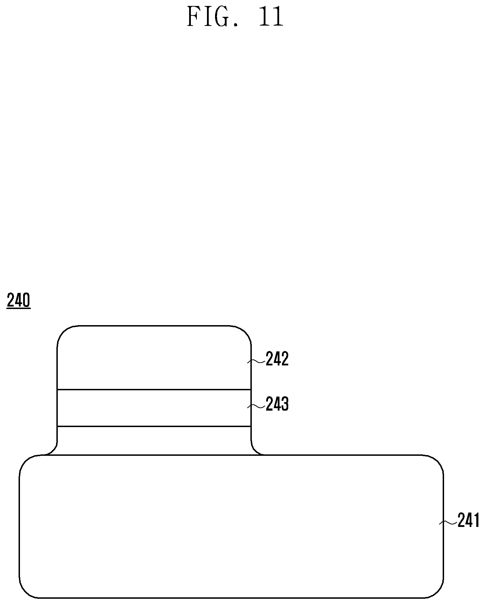

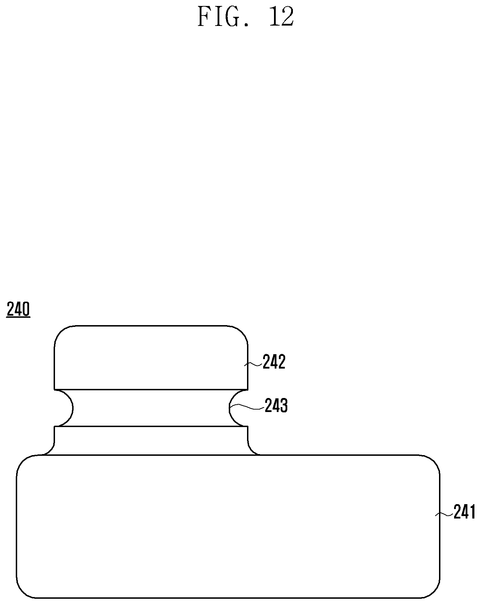

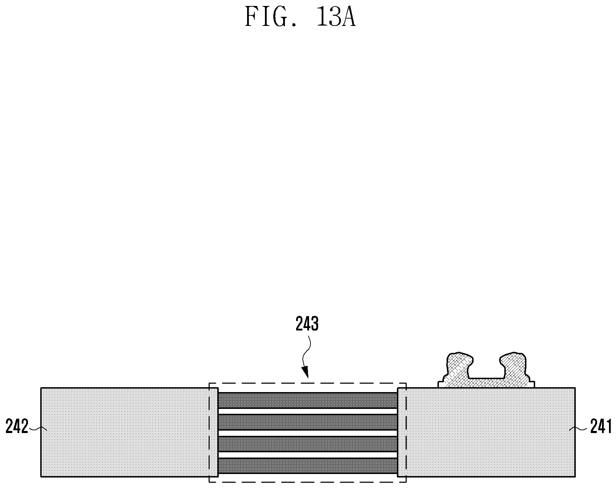

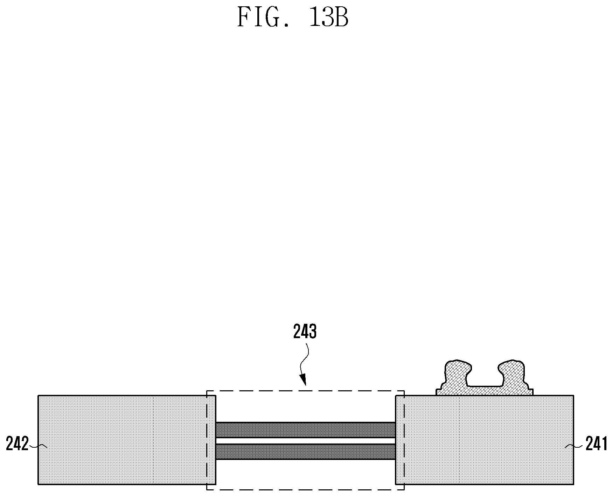

FIG. 11 is a schematic view illustrating the first rigid portion, the second rigid portion, and the first flexible portion, as viewed from above. FIG. 12 is a schematic view illustrating a case where the width of the first flexible portion of FIG. 11 is adjusted. FIG. 13A is a schematic view illustrating a case where the number of layers of the first flexible portion is increased, and FIG. 13B is a schematic view illustrating a case where the number of layers of the first flexible portion is reduced.

Referring to FIGS. 11 to 13B, a method of adjusting a reaction force of the first flexible portion 243 will be described.

In an embodiment, the tension of the first flexible portion 243 may be adjusted by the number of layers, width, wiring density, and/or pattern structure of the first flexible portion. As the number of layers of the first flexible portion 243 increases, the tension may increase, and as the number of layers decreases, the tension may decrease. As the width of the first flexible portion 243 increases, the tension may increase, and as the width decreases, the flexibility may increase. The wiring density and pattern structure of the first flexible portion 243 may affect mechanical strength and stress distribution of the first flexible portion 243.

In at least one embodiment of the disclosure, the tension of the first flexible portion 243 may be designed according to various requirements such as pressure of the thermal interface material 224 and prevention of connector disengagement. For example, the tension of the first flexible portion 243 may be adjusted to correspond to internal pressure generated when the thermal interface material 224 is injected, so as to meet purposes of preventing overflow or preventing connector disengagement. In this case, the tension of the first flexible portion 243 may be optimized according to folding operations, assembly processes, and durability requirements of the electronic device 200.

In an embodiment, the tension may be increased by increasing the number of layers of the first flexible portion 243 or by increasing its width. In an embodiment, a flexible portion having a larger number of layers and a greater width may provide higher restoring force and thereby enhance structural stability. For example, a four-layer flexible portion may provide tension at least 1.5 times greater than that of a two-layer structure. A flexible portion having a greater width may suppress deformation caused by external impact or pressure.

Referring to FIGS. 11 and 12, compared with FIG. 11, FIG. 12, illustrates a case where both ends of the first flexible portion 243 are cut so as to reduce that the width of the first flexible portion 243, thereby lowering its tension.

In at least one embodiment of the disclosure, when the tension of the first flexible portion 243 is designed to be high, the reaction force of the first flexible portion 243 against the pressure of the thermal interface material 224 may be increased, thereby focusing on preventing the overflow of the thermal interface material 224. For example, such a design may configure the structural restoring force of the first flexible portion 243 to 0.5 N or more, thereby suppressing the phenomenon in which the thermal interface material 224 pushes out the cover. Such a design may enhance adhesion between the second rigid portion 242 and the first cover member 250, thereby primarily blocking leakage of the thermal interface material 224.

In at least one embodiment of the disclosure, when the tension of the first flexible portion 243 is designed to be low, it may be suitable for environments requiring flexibility, such as preventing connector disengagement. Such a low-tension design may configure the structural restoring force of the first flexible portion 243 to 0.2 N or less, thereby suppressing the phenomenon in which the first connector 2412 is lifted due to an external impact. Accordingly, such a design may secure both durability and flexibility in the electronic device 200 in which folding operations are frequently performed.

In at least one embodiment of the disclosure, various patterns such as a mesh structure and a U-cut pattern may be applied to the first flexible portion 243 to adjust its tension. The mesh structure may arrange some of conductive patterns in a grid shape, thereby adjusting local rigidity of the first flexible portion 243. As illustrated in FIG. 12, a U-cut pattern may selectively reduce the tension of a specific area by cutting an outer edge of the first flexible portion 243.

In at least one embodiment of the disclosure, a mesh structure or a U-cut pattern may adjust local rigidity of the first flexible portion 243 so as to optimize overall stress distribution of the structure. The mesh structure may maintain central rigidity of the first flexible portion 243 while increasing flexibility of its outer edge. The U-cut pattern may adjust a curvature radius of the first flexible portion 243 to prevent stress concentration during folding operations.

In addition, the pattern design of the first flexible portion 243 may contribute not only to tension adjustment but also to optimization of wiring paths and improvement of heat dissipation characteristics. The mesh structure may minimize signal transmission delay by optimizing lengths of conductive patterns, and the U-cut pattern may improve heat dissipation efficiency by increasing a surface area of the flexible portion.

Referring to FIGS. 13A and 13B, the tension of the first flexible portion 243 may be adjusted by controlling the number of layers of the first flexible portion 243.

In at least one embodiment of the disclosure, when the wiring density of the layers increases, the mechanical rigidity of the first flexible portion 243 may increase, thereby improving resistance to an external force. The first flexible portion 243 having a high wiring density of the layers may prevent signal short-circuiting or disconnection in environments such as dropping, impact, or repetitive bending. An increase in mechanical rigidity may contribute to enhancing durability and reliability of the flexible portion.

In addition, in at least one embodiment of the disclosure, as illustrated in FIG. 13B, the tension may be lowered by reducing the number of layers of the first flexible portion 243. When the flexible portion is designed with two or less layers or its width is reduced to 3 mm or less, the structural restoring force may be reduced. Reduction in the number of layers and reducing of the width may reduce the bending radius of the flexible portion and increase flexibility.

In an embodiment, the first flexible portion 243 with a smaller number of layers may have increased flexibility and may ensure durability in repetitive bending environments. For example, when FIGS. 13A and 13B are compared, a two-layer structure of the first flexible portion 243 may provide flexibility increased by 30% or more compared to a four-layer structure.

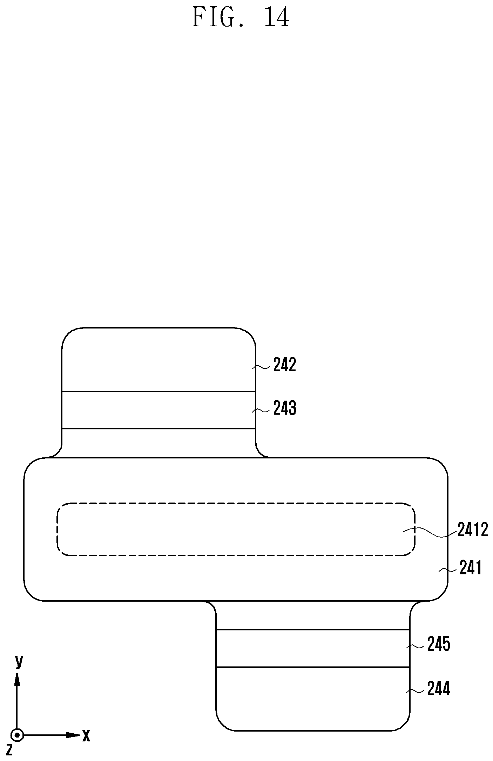

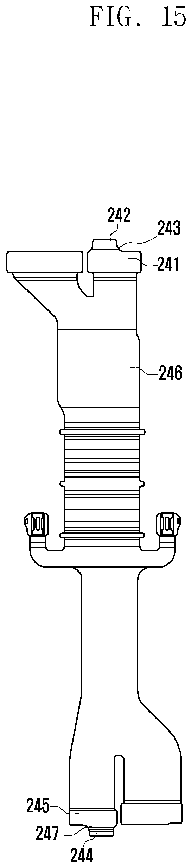

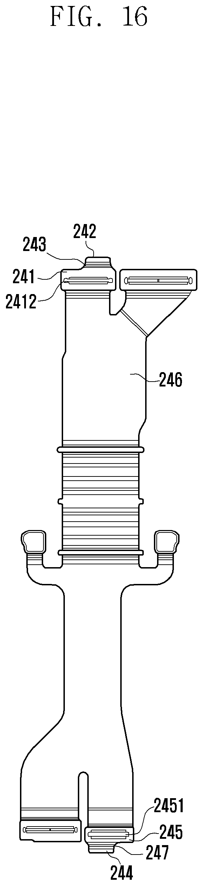

FIG. 14 is a schematic view illustrating a first rigid portion, a second rigid portion, and a third rigid portion, as viewed from above, FIG. 15 is a view illustrating a top surface of a flexible circuit substrate, and FIG. 16 is a view illustrating a bottom surface of the flexible circuit substrate.

Hereinafter, with reference to FIG. 8 and FIGS. 14 to 16, a multi-stiffener structure of a flexible circuit substrate 240 according to another embodiment of the disclosure will be described in detail.

The flexible circuit substrate 240 may include a third rigid portion 244 and a second flexible portion 247. The flexible circuit substrate 240 may be formed in a multi-stiffener structure including a first rigid portion 241, a second rigid portion 242, the third rigid portion 244, and the second flexible portion 247. The third rigid portion 244 may be disposed on one side of the flexible circuit substrate 240 to provide additional mechanical support and a thermal transfer path. The second flexible portion 247 may be positioned between the first rigid portion 241 and the third rigid portion 244 to electrically and mechanically connect the two rigid portions.

Such a multi-stiffener structure may block overflow of the thermal interface material 224 through a through-hole by the arrangement of respective rigid portions and the connection of the flexible portion. The articulated flexible portion may be designed such that when lifting of each stiffener occurs, disengagement of a corresponding connector portion may be prevented.

In an embodiment, each rigid portion and flexible portion of the flexible circuit substrate 240 may contribute to signal transmission, mechanical support, sealing reinforcement, and improvement of space efficiency in the electronic device 200. The first rigid portion 241 and the third rigid portion 244 may be responsible for mounting of a connector and securing of a thermal transfer path, respectively. The second flexible portion 247 may increase durability in repetitive bending environments and support stable transmission of signals. The combination of each rigid portion and flexible portion may increase the degree of freedom in component arrangement within the electronic device 200 and provide ease of assembly and maintenance.

The third rigid portion 244 may be disposed at one side of the flexible circuit substrate 240, and the second flexible portion 247 may connect the first rigid portion 241 and the third rigid portion 244. The third rigid portion 244 may be located at an end portion or a central portion of the flexible circuit substrate 240 and may be disposed at a position spaced apart from the first rigid portion 241.

Specifically, the third rigid portion 244 may be disposed opposite to the second rigid portion 242 with reference to the first rigid portion 241. The third rigid portion 244 may be disposed at a position opposite to the first rigid portion 241 to form a symmetrical structure of the flexible circuit substrate 240. The second rigid portion 242 and the third rigid portion 244 may be disposed on both sides of the first rigid portion 241, respectively, so as to achieve balanced load distribution within the electronic device 200. The third rigid portion 244 may include a second recess (not illustrated) overlapping a second through-hole (not illustrated), in which the second recess and the second through-hole may have the same shape as the first recess 2421 and the first through-hole 2211 of FIG. 8.

Such an arrangement of the third rigid portion 244 may increase the symmetry and space utilization of the flexible circuit substrate 240. The symmetrical structure may increase the degree of freedom in component arrangement within the electronic device 200 and may improve efficiency of the assembly process.

In at least one embodiment of the disclosure, when viewed in a direction perpendicular to the substrate surface of the first circuit board 221, at least a portion of a second through-hole (not illustrated) formed in the first circuit board 221 may overlap the third rigid portion 244. The third rigid portion 244 may be precisely aligned with the second through-hole (not illustrated) so as to support injection and sealing of the thermal interface material 224. The overlapping structure with the second through-hole (not illustrated) may simultaneously achieve alignment of a thermal transfer path and optimization of a signal routing path. In at least one embodiment of the disclosure, the overlapping structure of the third rigid portion 244 and the second through-hole (not illustrated) may contribute to alignment of the thermal transfer path and improvement of sealing performance. The overlapping structure may prevent the thermal interface material 224 from leaking to the outside and may allow efficient thermal transfer.

In various embodiments of the disclosure, the third rigid portion 244 of the flexible circuit substrate 240 may include a second recess (not illustrated) overlapping the second through-hole (not illustrated). The second through-hole (not illustrated) and the second recess (not illustrated) may have the same shape as the first through-hole 2211 and the first recess 2421 of FIG. 8. The second recess (not illustrated) may be formed by cutting or molding a portion of the third rigid portion 244. The second recess (not illustrated) may maximize the sealing effect through precise alignment with the through-hole. For example, the depth and shape of the second recess (not illustrated) may be designed to match the size and position of the through-hole.

The second recess (not illustrated) may provide a space for supporting injection and sealing of the thermal interface material 224. For example, overflowed thermal interface material 224 may be temporarily accommodated in the second recess (not illustrated), thereby preventing external leakage.

In at least one embodiment of the disclosure, the matching structure of the second recess (not illustrated) and the second through-hole (not illustrated) may contribute to sealing and prevention of external leakage of the thermal interface material 224. Precise alignment of the second recess (not illustrated) and the second through-hole (not illustrated) may block the thermal interface material 224 from leaking to the outside through the through-hole. For example, the second recess (not illustrated) may enlarge a contact surface with a cover member so as to reinforce the sealing effect.

The second flexible portion 247 may be continuously disposed between the first rigid portion 241 and the third rigid portion 244 to connect signal and power lines. A wiring pattern of the second flexible portion 247 may be designed to minimize signal interference.

In at least one embodiment of the disclosure, the design of the second flexible portion 247 may improve durability and reliability in repetitive bending environments. For example, the second flexible portion 247 may operate without damage even under repetitive bending in the electronic device 200 to which a folding or hinge structure is applied. The thickness, width, and wiring density of the second flexible portion 247 may be optimized according to a use environment.

In an embodiment, the electronic device 200 may further include a second cover member (not illustrated) disposed on the substrate surface of the first substrate 221 to close the second through-hole (not illustrated). The second cover member (not illustrated) may be formed of silicone, rubber, or metal material to completely seal the second through-hole (not illustrated).

In an embodiment, the second cover member (not illustrated) may seal the through-hole to block leakage of the thermal interface material 224. The second cover member (not illustrated) may be designed to match the size and position of the through-hole so as to prevent the thermal interface material 224 from leaking to the outside.

The second cover member (not illustrated) may be coupled with a stiffener and an elastic member to reinforce the sealing structure. The second cover member (not illustrated) may further include the elastic layer on a coupling surface with the stiffener to maintain a sealed state even under external impact or a pressure change. For example, an elastic member made of sponge or rubber may be inserted between the second cover member (not illustrated) and the stiffener.

In an embodiment, the electronic device 200 may further include a second opening (not illustrated) corresponding to the second recess (not illustrated), and a second elastic member (not illustrated) disposed between the second cover member (not illustrated) and the third rigid portion 244.

The second opening (not illustrated) may be precisely aligned with the second recess (not illustrated) to support injection and sealing of the thermal interface material 224. The second opening (not illustrated) may facilitate insertion of a dispenser during the injection process and may function as a portion of the sealing structure after injection. For example, the second opening (not illustrated) may be precisely aligned with the cover member to prevent external leakage of the thermal interface material 224.

The second elastic member (not illustrated) may be disposed between the cover member and the stiffener to provide pressing and buffering functions. The second elastic member (not illustrated) may be formed of rubber, sponge, or silicone material to serve as a buffer against external impact. For example, the second elastic member (not illustrated) may press the cover member with a constant pressure to maintain the sealed state. In this case, the second elastic member (not illustrated) may include a cavity structure to temporarily accommodate overflowed thermal interface material 224.

As illustrated in FIG. 14, the second rigid portion 242 and the third rigid portion 244 may be positioned diagonally with respect to the longitudinal direction of the first rigid portion 241. The second rigid portion 242 and the third rigid portion 244 may be arranged on opposite diagonal sides of the first rigid portion 241 to provide a tilt-offset mechanism in the Z-axis direction. Such a diagonal arrangement may allow the opposite rigid portions to compensate for tilt when each rigid portion is tilted, thereby maintaining stability of the overall structure. For example, when the second rigid portion 242 is lifted in the Z-axis direction, an opposite tilt of the third rigid portion 244 may offset the lifting, thereby preventing connector disengagement and maintaining the flatness of the flexible circuit substrate 240.

In addition, the diagonal arrangement of the second rigid portion 242 and the third rigid portion 244 may contribute to offsetting tilt in the Z-axis direction and securing structural stability. Such a diagonal arrangement may increase the degree of freedom in component arrangement within the electronic device 200, may improve efficiency of the assembly process, and may be effective in preventing connector disengagement and maintaining flatness. Furthermore, such a diagonal arrangement may mutually offset tilt influences of the rigid portions when deformation occurs during the assembly process or due to external impact, thereby preventing connector mis-insertion and structural deformation.

When the second rigid portion 242 and the third rigid portion 244 are diagonally arranged in this way, signal lines may be disposed on one side of the first rigid portion 241 to provide electrical and mechanical connections between the rigid portions. In at least one embodiment of the disclosure, the flexible circuit substrate 240 may include a fourth rigid portion 245 having a second connector 2451 disposed thereon, and a connection portion 246. The fourth rigid portion 245 may provide an additional mechanical support function for the flexible circuit substrate 240 and a mounting function for the second connector 2451.

In at least one embodiment of the disclosure, the second connector 2451 may be connected to at least one electronic component 230. The second connector 2451 may support electrical connection with a main substrate, a display, or another electronic component 230. The second connector 2451 may apply various types of contact structures to stably connect signal and power lines.

The fourth rigid portion 245 may provide additional connector mounting and signal distribution functions.

The fourth rigid portion 245 may be designed in a multilayer structure or extended pattern to mount a plurality of connectors or electronic components 230.

The connection portion 246 electrically and mechanically connects the first rigid portion 241 and the fourth rigid portion 245 and, when viewed in a direction perpendicular to the substrate surface of the first substrate 221, may overlap the battery 290. The connection portion 246 may be arranged to overlap the battery 290 so as to maximize space utilization within the electronic device 200. For example, the connection portion 246 may be disposed across an upper or lower portion of the battery 290, and the arrangement and shape of the connection portion 246 may be optimized according to space constraints within the electronic device 200.

In the electronic device according to the disclosure, in order to prevent thermal interface material injected into the sealed space of the multi-layered substrate from overflowing to the outside, the first recess is formed in the second rigid portion of the flexible circuit substrate and disposed to overlap the first through-hole of the multi-layered substrate. As a result, the overflow of the thermal interface material may be effectively suppressed.

In addition, by connecting the first rigid portion and the second rigid portion of the flexible circuit substrate with a first flexible portion, disengagement of the connector may be prevented despite tilting of a stiffener that may occur due to pressure of the thermal interface material.

In addition, by including the first cover member disposed on the substrate surface of the first substrate to close the first through-hole, the first opening corresponding to the first recess, and the first elastic member disposed between the first cover member and the second rigid portion, a secondary prevention effect against overflow of the thermal interface material, as well as a pressing and tolerance compensation effect of the cover member, may be obtained.

Furthermore, by designing the thickness of the first flexible portion to be smaller than those of the first rigid portion and the second rigid portion, or by designing the thickness of the second rigid portion to be greater than that of the first rigid portion, structural stability against the pressure of the thermal interface material and connector disengagement may be further improved.

In addition, by including a plurality of rigid portions and flexible portions in the flexible circuit substrate and applying recesses and elastic members to each rigid portion, structural flexibility corresponding to a plurality of thermal interface material injection ports may be provided.

## Claims

1. An electronic device comprising:
a housing;
a multi-layered substrate disposed in the housing;
at least one electronic component disposed in the housing; and
a flexible circuit substrate configured to electrically connect the multi-layered substrate and the at least one electronic component,
wherein the multi-layered substrate comprises:
a first substrate;
a second substrate spaced apart from the first substrate;
an interposer disposed between the first substrate and the second substrate to electrically connect the first substrate and the second substrate; and
a thermal interface material injected into a space defined by the first substrate, the second substrate, and the interposer through a first through-hole formed in the first substrate,
wherein the flexible circuit substrate comprises:
a first rigid portion disposed at one end of the first flexible circuit board and having a first connector connected to a connection portion disposed on the first substrate;
a second rigid portion spaced apart from the first rigid portion and comprising a first recess formed on one surface of the second rigid portion facing the first substrate; and
a first flexible portion connecting the first rigid portion and the second rigid portion, and
wherein, when viewed in a direction perpendicular to a substrate surface of the first substrate, at least a portion of the first through-hole overlaps the first recess of the second rigid portion.

2. The electronic device of claim 1, further comprising:
a first cover member disposed on the substrate surface of the first substrate to close the first through-hole.

3. The electronic device of claim 2, further comprising:
a first elastic member which comprises a first opening corresponding to the first recess and is disposed between the first cover member and the second rigid portion.

4. The electronic device of claim 3, wherein the first elastic member is configured to press the first cover member.

5. The electronic device of claim 1, wherein the first flexible portion has a thickness smaller than that of the first rigid portion and that of the second rigid portion.

6. The electronic device of claim 1, wherein the second rigid portion has a thickness greater than that of the first rigid portion.

7. The electronic device of claim 1, wherein the flexible circuit substrate comprises a third rigid portion positioned opposite to the second rigid portion with reference to the first rigid portion, and a second flexible portion connecting the first rigid portion and the third rigid portion, and
wherein, when viewed in a direction perpendicular to the substrate surface of the first substrate, at least a portion of a second through-hole formed in the first substrate overlaps the third rigid portion.

8. The electronic device of claim 7, wherein the third rigid portion of the flexible circuit substrate comprises a second recess overlapping the second through-hole.

9. The electronic device of claim 8, further comprising:
a second cover member disposed on the substrate surface of the first substrate to close the second through-hole.

10. The electronic device of claim 9, further comprising:
a second elastic member comprising a second opening corresponding to the second recess and is disposed between the second cover member and the third rigid portion.

11. The electronic device of claim 7, wherein the second rigid portion and the third rigid portion are positioned diagonally with respect to a longitudinal direction of the first rigid portion.

12. The electronic device of claim 1, further comprising:
a battery disposed between the flexible circuit board and the at least one electronic component,
wherein the flexible circuit substrate comprises:
a fourth rigid portion disposed at one end of the flexible circuit board;
a second connector disposed in the fourth rigid portion and connected to the at least one electronic component; and
a connection portion configured to connect the first rigid portion and the fourth rigid portion and overlapping the battery when viewed in a direction perpendicular to the substrate surface of the first substrate.

13. The electronic device of claim 1, wherein the housing comprises a first housing and a second housing,
wherein the electronic device further comprises a hinge assembly configured to rotatably connect the first housing and the second housing about a folding axis, and
wherein a longitudinal side of the first connector of the multi-layered substrate is substantially parallel to the folding axis.

14. The electronic device of claim 2, wherein the first cover member has an incision portion into which a dispenser configured to inject the thermal interface material is inserted.

15. An electronic device comprising:
a housing;
a multi-layered substrate disposed in the housing;
at least one electronic component disposed in the housing; and
a flexible circuit substrate configured to electrically connect the multi-layered substrate and the at least one electronic component,
wherein the multi-layered substrate comprises:
a first substrate;
a second substrate spaced apart from the first substrate;
an interposer disposed between the first substrate and the second substrate and configured to electrically connect the first substrate and the second substrate and provide a sealed space; and
a thermal interface material injected into the sealed space through a first through-hole formed in the first substrate,
wherein the flexible circuit substrate comprises:
a first rigid portion disposed at one end of the flexible circuit substrate and having a connector disposed thereon to be connected to a connection portion disposed on the first substrate;
a second rigid portion spaced apart from the first rigid portion; and
a first flexible portion connecting the first rigid portion and the second rigid portion, and
wherein, when viewed in a direction perpendicular to the substrate surface of the first substrate, at least a portion of the first through-hole overlaps the second rigid portion.
